# FASCICULE DE BREVET EUROPEEN

(11) **EP 2 922 626 B1**
(45) Date de publication et mention de la délivrance du brevet: **25.09.2019**
(21) Numéro de dépôt: 13802270.2
(22) Date de dépôt: 25.11.2013
(51) Int. Cl.: B01J 19/12

(54) **DISPOSITIF POUR LA SYNTHESE DE NANOPARTICULES DE TYPE COEUR-COQUILLE PAR PYROLYSE LASER ET PROCEDE ASSOCIE.**
VORRICHTUNG ZUR SYNTHESE VON KERN-HÜLLE-NANOPARTIKELN DURCH LASERPYROLYSE UND ZUGEHÖRIGES VERFAHREN
DEVICE FOR SYNTHESISING CORE-SHELL NANOPARTICLES BY LASER PYROLYSIS AND ASSOCIATED METHOD

(30) Priorité: 26.11.2012 FR 1261243
(43) Date de publication de la demande: 30.09.2015
(73) Titulaire: Commissariat à l'Énergie Atomique et aux Énergies Alternatives, 75015 Paris (FR)
(72) Inventeur: LECONTE, Yann, F-78470 Saint-remy Les Chevreuse (FR); SUBLEMONTIER, Olivier, F-92260 Fontenay Aux Roses (FR); HERLIN-BOIME,Nathalie, F-91400 Orsay (FR); REYNAUD, Cécile, F-94230 Cachan (FR); PORTERAT, Dominique, F-91400 Orsay (FR); QUINSAC, Axelle, F-78180 Montigny-le-bretonneux (FR)
(74) Mandataire: Gevers & Orès
(86) Numéro de dépôt international: PCT/EP2013/074537
(87) Numéro de publication internationale: WO 2014/079997

(56) Documents cités:
- WO-A1-2006/051233
- WO-A1-2007/065870
- US-A1- 2003 157 867
- LECONTE ET AL: "Application of the laser pyrolysis to the synthesis of SiC, TiC and ZrC pre-ceramics nanopowders", JOURNAL OF ANALYTICAL AND APPLIED PYROLYSIS, ELSEVIER BV, NL, vol. 79, no. 1-2, 19 avril 2007 (2007-04-19), pages 465-470, XP022062395, ISSN: 0165-2370, DOI: 10.1016/J.JAAP.2006.11.009

## Description

La présente invention concerne un dispositif et un procédé de synthèse de nanoparticules de type coeur-coquille par pyrolyse laser.

Par nanoparticules, on entend des particules dont les dimensions sont inférieures au micron.

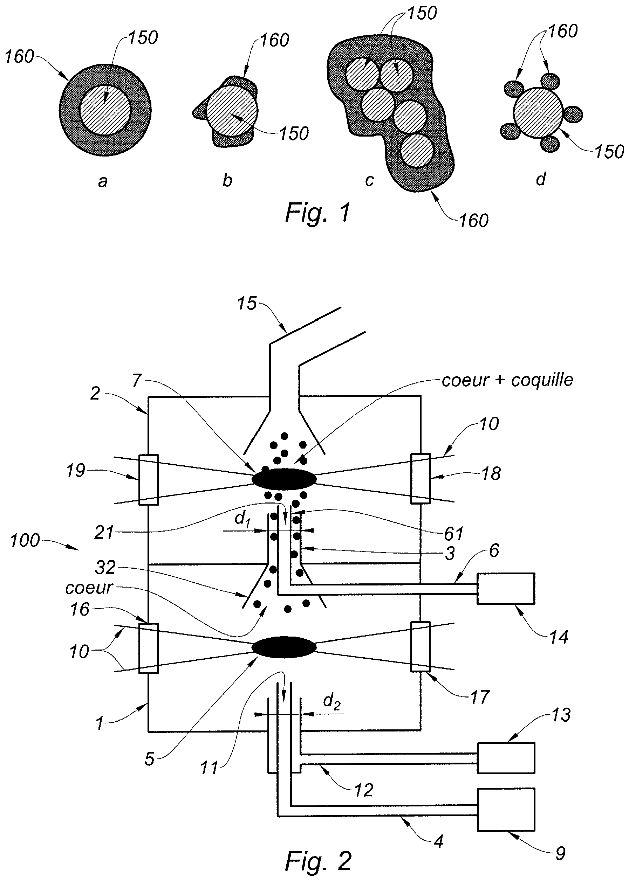

Les nanoparticules de type coeur-coquille sont formées d'un coeur enrobé par une coquille. Cet enrobage peut être intégral ou partiel comme le montre les différents schémas a, b, c et d de la figure 1. Sur ces schémas, le coeur est référencé 150 et la coquille 160.

La pyrolyse laser est largement employée pour synthétiser les nanoparticules de type coeur-coquille.

Un exemple de dispositif employé est proposé dans l'article de Veintemillas-Verdaguer & al., « Continous production of inorganic magnetic nanocomposites for biomedical applications by laser pyrolysis », Journal of Magnetism and Magnetic Materials 311 (2007), pp. 120-124 (D1).

Dans l'article D1, le dispositif de synthèse de nanoparticules de type coeur-coquille par pyrolyse laser comprend une chambre, une entrée dans la chambre pour les précurseurs du coeur et de la coquille et un laser agencé pour éclairer ces précurseurs dans la chambre afin de former les nanoparticules. De ce fait, les précurseurs du coeur et de la coquille sont injectés ensemble dans la chambre.

Ce dispositif est intéressant car il permet de former des nanoparticules de type coeur-coquille en continu.

Les auteurs fournissent des exemples de nanoparticules susceptibles d'être synthétisées avec ce dispositif. Il s'agit de nanoparticules dont le coeur est en Fer (Fe) et la coquille en carbone (C) ou, en fonction des précurseurs utilisés, de nanoparticules dont le coeur est en Fer (Fe) et la coquille en dioxyde de silicium (SiO₂). US2003/0157867 décrit un procédé de production de nanoparticules par pyrolyse laser avec une chambre de traitement.

Cependant, un inconvénient majeur de ce dispositif est qu'il ne permet par de former tous types de nanoparticules de type coeur-coquille.

En effet, pour former ces nanoparticules, le coeur doit être formé en premier puis la coquille doit être formée et déposée autour du coeur préalablement formé.

Avec ce dispositif, la thermodynamique interdit donc la formation de certaines nanoparticules de type coeur-coquille. Par exemple, si ce dispositif permet de former des nanoparticules dont le coeur est en Fer (Fe) et dont la coquille est en Carbone (C), il ne permet pas de former des nanoparticules de structure inverse, à savoir dont le coeur est en Carbone (C) et la coquille en Fer (Fe).

De plus, en fonction de la nature des précurseurs en présence, certains mélanges de précurseurs aboutiront à la formation de nanoparticules qui ne sont pas du type coeur-coquille, mais à des nanoparticules constituées par un alliage ou des phases complexes des matériaux en présence.

Il convient par ailleurs de noter qu'il existe des dispositifs de synthèse de nanoparticules de type coeur-coquille qui, contrairement au dispositif proposé dans l'article D1, peuvent synthétiser des nanoparticules indépendamment de la nature chimique du coeur et de la coquille.

Pour cela, la synthèse des nanoparticules est réalisée avec des étapes successives de synthèse du coeur puis de synthèse de la coquille qui utilisent des techniques différentes.

Par exemple, Yoon Hwa & al., «High capacity and rate capability of core-shell structured nano-Si/C anode for Li-ion batteries », Electrochemica Acta 71(2012), pp. 201-205 (D2) proposent un procédé pour la synthèse de nanoparticules dont le coeur est en silicium (Si) et la coquille en Carbone (C).

Le coeur en silicium est réalisé par voie chimique. Dans le cas d'espèce, du silicium se présentant sous forme d'une nanopoudre est plongée dans une solution spécifique, préalablement préparée. Puis, la solution est agitée pendant 5mn. La solution est ensuite passée sous centrifugeuse à plusieurs reprises, chaque passage en centrifugeuse durant 10mn. Un séchage est ensuite effectué à 60°C pendant 24h pour récupérer les nanoparticules destinées à former le coeur des nanoparticules de type coeur-coquille.

Puis, la coquille en carbone est réalisée par voie physique. Dans le cas d'espèce, il s'agit d'une opération de calcination s'effectuant à 750°C pendant 3h, sous atmosphère neutre.

La synthèse des nanoparticules s'effectue donc en deux étapes bien distinctes et utilisent par ailleurs des techniques différentes.

Si l'approche proposée dans l'article D2 permet de former des nanoparticules de type coeur-coquille avec des constituants plus variés qu'avec la pyrolyse laser proposée dans l'article D1, cette approche est cependant bien plus longue à mettre en oeuvre.

De plus, elle ne peut pas s'effectuer en continu au sein d'un même dispositif car elle requière la mise en oeuvre de techniques différentes (voie chimique pour le coeur, voie physique pour la coquille).

Un objectif de l'invention est de proposer une solution qui s'affranchit des inconvénients précités.

Ainsi, un objectif de l'invention est de proposer une solution permettant de synthétiser des nanoparticules de type coeur-coquille en continu pour une gamme étendue de matériaux formant le coeur et la coquille.

Avantageusement, un objectif de l'invention est de proposer une solution permettant de synthétiser des nanoparticules de type coeur-coquille en continu quelle que soit la nature chimique des matériaux formant le coeur et la coquille.

Pour atteindre l'un au moins de ces objectifs, l'invention propose un dispositif de synthèse de nanoparticules de type coeur-coquille par pyrolyse laser, caractérisé en ce qu'il comprend :
- un réacteur comportant :
   - une première chambre pour la synthèse du coeur, laquelle est munie d'une entrée pour un précurseur du coeur ;
   - une deuxième chambre pour la synthèse de la coquille, laquelle est munie d'une entrée pour un précurseur de la coquille ; et
   - au moins un canal de communication entre les deux chambres pour transmettre le coeur des nanoparticules destinées à être formées dans la première chambre en direction de la deuxième chambre ;
- un dispositif optique pour éclairer chacune des deux chambres, ce dispositif comportant au moins un laser apte à émettre un faisceau laser destiné à interagir avec lesdits précurseurs afin de former le coeur et la coquille.

Le dispositif selon l'invention pourra également comprendre les caractéristiques suivantes, prises seules ou en combinaison :
- le dispositif optique comprend une pluralité de miroirs agencés de sorte que le faisceau laser émis par le laser soit apte à éclairer successivement les deux chambres ;
- le dispositif optique comprend au moins une lame séparatrice pour régler la puissance du faisceau laser dans chacune des deux chambres, cette lame séparatrice étant par exemple située entre deux miroirs ;
- le dispositif optique comprend une lame séparatrice et au moins un miroir agencés de sorte que le faisceau laser émis par le laser soit divisé en deux faisceaux chacun apte à éclairer l'une des deux chambres ;
- le dispositif optique comprend un premier laser pour éclairer la première chambre et un deuxième laser pour éclairer la deuxième chambre ;
- le dispositif optique comprend au moins un moyen de focalisation disposé entre le ou chaque laser et au moins l'une des deux chambres ;
- la distance entre ledit au moins un moyen de focalisation et la chambre avoisinante est réglable ;
- le moyen de focalisation comportant deux lentilles cylindriques, la distance entre les deux lentilles cylindriques est réglable ;
- l'entrée du précurseur de la coquille dans la deuxième chambre forme une extrémité d'un canal d'amenée de ce précurseur dont une partie est logée à l'intérieur du canal de communication entre les deux chambres ;
- l'entrée du précurseur de la coquille dans la deuxième chambre forme une extrémité d'un canal d'amenée de ce précurseur dont une partie entoure le canal de communication entre les deux chambres ;
- la partie du canal d'amenée du précurseur de la coquille qui est, selon le cas, logée à l'intérieur du canal de communication ou qui entoure ce canal de communication s'étend colinéairement avec le canal de communication ;
- le réacteur comprend un canal d'amenée du précurseur de la coquille débouchant dans le canal de communication entre les deux chambres, l'entrée du précurseur de la coquille se confondant alors avec l'extrémité du canal de communication entre les deux chambres qui débouche dans la deuxième chambre ;
- le réacteur comprend un canal complémentaire de communication entre les deux chambres, entourant le canal de communication entre ces deux chambres ;
- l'entrée du précurseur du coeur dans la première chambre forme une extrémité d'un canal d'amenée de ce précurseur dont une partie est entourée par une partie d'un canal relié à une source de gaz neutre ;
- la partie du canal d'amenée du précurseur du coeur qui est entourée par une partie du canal relié à la source de gaz neutre s'étend colinéairement avec cette partie dudit canal.

Pour atteindre l'un au moins de ces objectifs, l'invention propose également un procédé de synthèse de nanoparticules de type coeur-coquille par pyrolyse laser, caractérisé en ce qu'il comprend les étapes suivantes :
(a) injecter un précurseur du coeur dans une première chambre d'un réacteur;
(b) éclairer le précurseur du coeur par un faisceau laser afin de former par pyrolyse le coeur des nanoparticules ;
(c) transporter le coeur des nanoparticules ainsi formé à l'étape (b) dans une deuxième chambre du réacteur communiquant avec la première chambre ;
(d) injecter un précurseur de la coquille dans la deuxième chambre du réacteur ;
(e) éclairer le précurseur de la coquille avec un faisceau laser afin de former par pyrolyse la coquille des nanoparticules et d'assurer le dépôt de cette coquille autour du coeur.

Le procédé selon l'invention pourra également comprendre les caractéristiques suivantes, prises seules ou en combinaison :
- l'étape (a) et/ou l'étape (d) s'effectue(nt) à l'aide d'un gaz neutre tel que l'argon ;
- le procédé comprend une étape consistant à modifier la distance entre un moyen de focalisation du faisceau laser et la chambre du réacteur avoisinante ;
- la pression régnant dans la première chambre est plus élevée que la pression régnant dans la deuxième chambre.

D'autres caractéristiques, buts et avantages de l'invention seront énoncés dans la description détaillée ci-après faite en référence aux figures suivantes :
- la figure 2 est un schéma représentant un réacteur du dispositif selon l'invention ;
- les figures 3(a) à 3(d) représentent plusieurs variantes d'un dispositif selon l'invention, chaque variante se distinguant l'une de l'autre par le dispositif optique utilisé avec le réacteur représenté sur la figure 1 ;
- la figure 4 est un schéma représentant une variante du réacteur représenté sur la figure 1, laquelle est susceptible d'être employée en combinaison avec l'un quelconque des dispositifs optiques représentés sur les figures 3(a) à 3(d) ;
- la figure 5 est un schéma représentant une variante du réacteur représenté sur la figure 1, laquelle est également susceptible d'être employée en combinaison avec l'une quelconque des dispositifs optiques représentés sur les figures 3(a) à 3(d).

Sur la figure 2, le réacteur 100 comprend une première chambre 1, une deuxième chambre 2 et un canal de communication 3 entre les deux chambres 1, 2. Dans le cas d'espèce, le réacteur 100 est disposé verticalement, si bien que la deuxième chambre 2 se situe au-dessus de la première chambre 1.

La première chambre 1 est munie d'une entrée 11 pour un précurseur du coeur. La deuxième chambre 2 est également munie d'une entrée 21, en l'occurrence pour un précurseur de la coquille. De ce fait, la première chambre 1 est dédiée à la synthèse du coeur et la deuxième chambre 2 à la synthèse de la coquille et à la formation définitive des nanoparticules de type coeur-coquille.

Les entrées 11, 21 se présenteront généralement sous la forme de buses d'injection.

La synthèse du coeur et de la coquille s'effectue donc successivement dans le temps et dans l'espace. Pour autant, la production des nanoparticules s'effectue bien en continu en alimentant chaque entrée 11, 21 en flux continu par un précurseur dédié, selon le cas, à la synthèse du coeur ou à la synthèse de la coquille.

Ce réacteur permet de limiter la formation d'oxydes ou de composés chimiques autres que les nanoparticules de type coeur-coquille du fait du temps d'exposition réduit à l'air ambiant du coeur en silicium dans la première chambre 1, notamment en raison d'un mode de production en continu. De plus, ce réacteur limite la formation éventuelle, dans la deuxième chambre 2, d'alliages entre les matériaux formant le coeur et la coquille, notamment en raison d'une formation successive du coeur, puis de la coquille.

De plus, le fait d'avoir deux chambres 1, 2 bien distinctes, reliées par un canal de communication 3 permet de mieux contrôler les mouvements de particules de coeur (silicium) pour les conduire vers la zone d'intérêt de la deuxième chambre 2, en limitant les risques que ces particules de coeurs viennent par exemple au contact des parois de la deuxième chambre 2 et soient donc chimiquement polluées.

La pression peut être la même dans les deux chambres. Cependant, le fait de mettre en oeuvre deux chambres 1, 2 distinctes, reliées par un canal de communication 3 permet l'établissement d'un différentiel de pression entre les deux chambres 1, 2. Dans un tel cas, la première chambre 1, à plus haute pression, favorise la nucléation homogène du coeur (silicium, par exemple) et la deuxième chambre 2, à plus basse pression, favorise la nucléation hétérogène, à savoir la croissance de la coquille autour du coeur (carbone autour du silicium, par exemple), par rapport à la nucléation hétérogène. Cela permet d'améliorer l'efficacité du dépôt homogène de la coquille autour du coeur.

L'entrée 11 de la première chambre 1 est reliée à un canal d'amenée 4 du précurseur du coeur, ce canal 4 étant relié à une source 9 pour le précurseur du coeur.

Un gaz neutre est amené dans la première chambre 1 par un conduit 12 dont une partie entoure le canal 4, ledit conduit 12 étant par ailleurs relié à une source 13 de ce gaz.

Ce gaz neutre sert principalement au confinement de la zone d'interaction. Ceci permet d'éviter tout contact entre le précurseur et les parois de la chambre, limitant ainsi les risques de réaction chimique avec les précurseurs du silicium du coeur et/ou de la coquille. Ce gaz neutre évite également toute oxydation du coeur une fois formé avec l'air environnant.

Grâce à ce confinement, on limite encore plus, voire on évite, toute pollution du coeur. Le coeur garde ainsi son intégrité chimique, sans formation d'oxydes ou d'autres composés chimiques.

Ce gaz neutre peut éventuellement également aider au transport du coeur des nanoparticules.

De plus, l'introduction colinéaire du gaz neutre et des précurseurs du coeur favorise un peu plus ce confinement. Cette colinéarité est liée au fait que la partie du canal 12 qui entoure la partie du canal 4 s'étend selon la même direction. Cette colinéarité se retrouve d'ailleurs au niveau du canal de communication 3, lequel s'étend avantageusement selon la direction d'introduction des précurseurs du coeur et du gaz neutre au niveau de l'entrée 11.

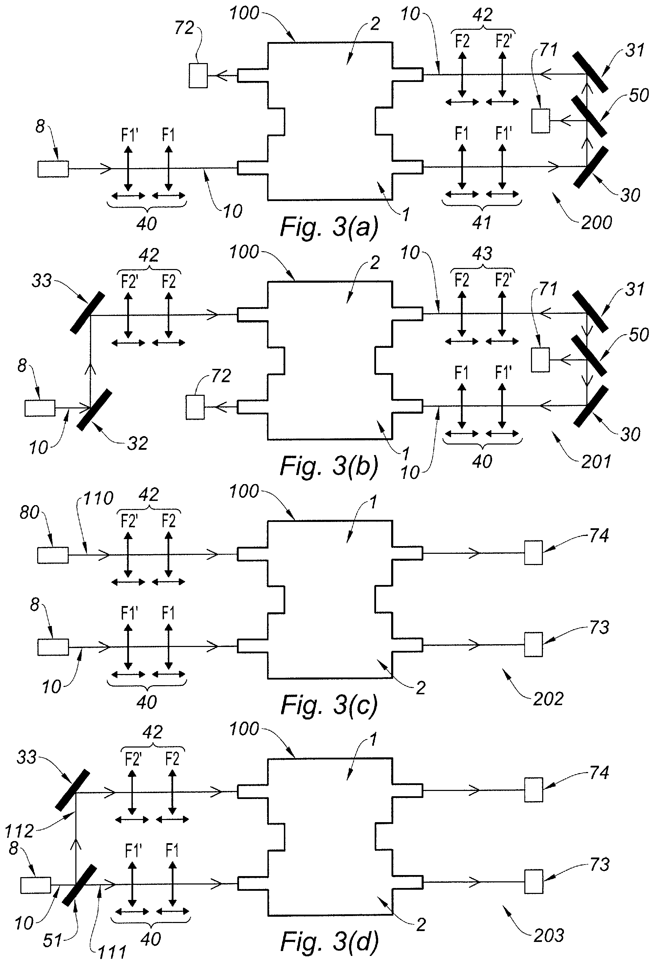

Le faisceau laser 10 est émis par un dispositif optique 200, 201, 202, 203 comportant à cet effet un laser situé à l'extérieur des chambres 1, 2 du réacteur 100. Ce dispositif optique sera décrit par la suite de façon plus détaillée à l'appui des figures 3(a) à 3(d). En passant dans cette première zone d'interaction 5, le précurseur du coeur forme le coeur des nanoparticules par pyrolyse.

Le coeur ainsi formé est alors amené dans le canal de communication 3 entre les deux chambres 1, 2. Ce canal de communication 3 sert à transmettre le coeur des nanoparticules formées dans la première chambre 1 en direction de la deuxième chambre 2. A cet effet, il est avantageusement muni d'une partie inférieure conique 32. A cet effet également, le flux de gaz neutre aide avantageusement au transfert du coeur des nanoparticules vers la deuxième chambre 2.

Parallèlement à la transmission du coeur des nanoparticules vers la deuxième chambre 2, un précurseur de la coquille est amené dans la deuxième chambre 2. A cet effet, l'entrée 21 de la deuxième chambre 20 forme une extrémité d'un canal d'amenée 6 de ce précurseur, relié à une source 14 pour ce précurseur. Dans le cas d'espèce, une partie 61 de ce canal d'amenée est logée à l'intérieur du canal de communication 3 entre les deux chambres 1, 2 (figure 2).

Il convient de noter que la partie 61 s'étend selon la longueur du canal de communication 3 (colinéarité). Par ailleurs, les précurseurs de la coquille, une fois introduits dans la deuxième chambre 2, suivent le même mouvement linéaire des particules de coeur et du gaz neutre accompagnant ces particules. Cela limite également la dispersion des particules du coeur dans la deuxième chambre 2.

Le coeur des nanoparticules et le précurseur de la coquille se mélangent donc dans la deuxième chambre 2. Ce mélange doit s'effectuer avant une deuxième zone d'interaction 7 avec le faisceau laser 10. A cet égard, les conditions de débit pour chaque précurseur doivent être contrôlées.

Le précurseur de la coquille des nanoparticules est ainsi amené, avec le coeur des nanoparticules, dans la zone d'interaction 7 avec le faisceau laser 10 afin de former la coquille et les nanoparticules coeur-coquille. Ce faisceau laser 10 est généré par le dispositif optique précité.

Une fois les nanoparticules coeur-coquille formées, elles sont extraites du réacteur 100 par le biais d'un canal 15 de récupération de ces nanoparticules, comportant avantageusement des collecteurs avec des barrières filtrantes.

L'alimentation en précurseur de chaque chambre 1, 2 est faite de manière indépendante. En pratique, cela permet donc de former tout type de nanoparticule de type coeur-coquille.

Par ailleurs, le dispositif 100 permet d'obtenir des nanoparticules de type coeur-coquille avec une répartition homogène de la coquille autour du coeur.

De plus, les précurseurs peuvent se présenter sous forme de gaz, de liquide ou de solide.

A titre d'exemple, on peut envisager des précurseurs gazeux de type silane, éthylène ou diborane.

On peut envisager des précurseurs liquides de type isopropoxyde de titane. On peut également envisager d'ajouter de l'acétylène, du tétrachlorure de titane, du butoxyde de zirconium ou d'aluminium, les acétonates, les acétylacétonates, nitrates de métaux ou de terres rares et plus généralement tous les précurseurs organométalliques utilisés pour le dépôt chimique en phase vapeur, dans la mesure où ceux-ci sont mélangées avec un sensibilisateur leur permettant d'absorber la radiation laser.

On peut enfin envisager des poudres solides, comme de la nanopoudre de Zinc, avantageusement amenée dans un gaz porteur neutre.

Nous allons maintenant décrire différents dispositifs optiques susceptibles d'être employés avec le réacteur 100 représenté sur la figure 1. Chaque dispositif optique a pour fonction d'éclairer chacune des deux chambres et comprend, à cet effet, au moins un laser.

Sur la figure 3(a), le dispositif optique 200 comprend un laser 8 et un jeu de deux miroirs 30, 31. Le laser 8 est disposé sur le côté de la première chambre 1 pour éclairer celle-ci en premier. Le faisceau laser 10 présente un axe de propagation sécant à la verticale et, dans le cas d'espèce, horizontal. La première chambre 1 comprend donc des parois latérales transparentes 16, 17 au faisceau laser 10 pour permettre au faisceau laser de la traverser de part en part, selon un axe sensiblement horizontal.

On pourrait prévoir un autre agencement respectif du laser 8 par rapport au réacteur 100. Cependant, cet agencement est particulièrement pratique pour faire en sorte que le faisceau laser soit apte à interagir avec lesdits précurseurs afin de former le coeur et la coquille.

Le jeu de miroirs 30, 31 permet de rediriger le faisceau laser 10 issu de la première chambre 1 en direction de la deuxième chambre 2, afin que le faisceau laser traverse la deuxième chambre selon un axe de propagation sécant à la verticale et, dans le cas d'espèce, horizontal. La deuxième chambre 2 comprend donc des parois latérales transparentes 18, 19 au faisceau laser 10.

Avantageusement, les miroirs 30, 31 seront plans et associés à un ou plusieurs moyens de focalisation 40, 41, 42. Ainsi, et comme représenté sur la figure 3(a), il est possible de mettre en oeuvre un premier moyen de focalisation 40 entre le laser 8 et la première chambre 1, un deuxième moyen de focalisation 41 entre la première chambre 1 et le miroir 30 (afin de re-collimater le faisceau laser 10 issu de la première chambre 1 avant le passage par les miroirs 30, 31) et enfin, un troisième moyen de focalisation 42 entre le miroir 31 et la deuxième chambre 2.

En variante, on peut supprimer le troisième moyen de focalisation 42 en conservant les deux autres moyens de focalisation 40, 41. Dans ce cas, seul le faisceau laser 10 passant par la première chambre 1 est focalisé.

Selon une autre variante, il est encore possible de conserver uniquement le troisième moyen de focalisation 42, sans mettre en oeuvre les deux autres 40, 41. Dans ce cas, seul le faisceau laser 10 passant par la deuxième chambre 2 est focalisé.

Par ailleurs, ces miroirs plans 30, 31 peuvent être mis en oeuvre seuls, sans moyen de focalisation.

Une lame séparatrice 50 peut être prévue entre les deux chambres 1, 2 sur le parcours du faisceau laser 10, et avantageusement entre les deux miroirs 30, 31. Par exemple, on peut envisager une lame séparatrice 50 en ZnSe.

L'introduction d'une lame séparatrice 50 permet de contrôler la puissance du faisceau laser 10 traversant la deuxième chambre 2, laquelle est dans ce cas nécessairement plus faible que la puissance du faisceau laser 10 traversant la première chambre 1.

Ceci peut avoir un intérêt en fonction de la nature chimique des précurseurs injectés dans les chambres 1, 2. En effet, certains précurseurs nécessitent moins d'énergie que d'autres pour être décomposés. Ceci peut également avoir un intérêt pour contrôler les caractéristiques structurales des nanoparticules de type coeur-coquille finalement attendues. En effet, cela nécessite des températures plus ou moins élevées qui peuvent être contrôlées avec la lame séparatrice 50.

Des moyens d'arrêt 71, 72 du faisceau laser sont prévus, notamment en sortie de la deuxième chambre 2.

Il convient de noter que les miroirs plans 30, 31 pourraient être remplacés par des miroirs concaves. De tels miroirs permettent non seulement de rediriger le faisceau laser 10 d'une chambre vers l'autre comme les miroirs plans, mais ils assurent aussi la fonction de focalisation du faisceau laser 10. Un moyen de focalisation n'est donc plus nécessaire avec un miroir concave. Par exemple, il est envisageable de remplacer le miroir 31 et le moyen de focalisation 42 par un tel miroir concave.

Dans ce cas, l'emplacement des miroirs concaves est important pour définir correctement les zones de focalisation du faisceau laser dans chaque chambre 1, 2, ces zones de focalisation définissant les zones d'interaction 5, 7 avec les précurseurs.

La variante 201 du dispositif optique 200 présentée à l'appui de la figure 3(a) ne permet donc pas d'obtenir une puissance du faisceau laser 10 plus élevée dans la deuxième chambre 2 que dans la première chambre 1.

Pour cette raison, et en fonction de la nature chimique des précurseurs du coeur et de la coquille, il est envisageable d'inverser le montage, c'est-à-dire de faire passer le faisceau laser 10 issu du laser 8 en premier lieu par la deuxième chambre 2 puis, par la première chambre 1.

Cette possibilité est représentée sur la figure 3(b).

Par rapport à la figure 3(a), le laser 8 n'a pas changé de place par rapport au réacteur 100. Un jeu de miroirs 30, 31, 32, 33 est prévu pour faire passer le faisceau laser 10 par la deuxième chambre 2 puis par la première chambre 1.

Avantageusement, les miroirs 30, 31, 32, 33 sont des miroirs plans associés à des moyens de focalisation 41, 42, 44 dont certains 41, 44 servent à définir les zones d'interactions avec les précurseurs dans les chambres 1, 2.

Ainsi, et comme représenté sur la figure 3(b), il est possible de mettre en oeuvre un premier moyen de focalisation 42 entre le laser 8 et la deuxième chambre 2 et plus précisément après le miroir 33, un deuxième moyen de focalisation 43 entre la deuxième chambre 2 et le miroir 31 (pour re-collimater le faisceau laser 10 issu de la deuxième chambre 2 avant le passage par les miroirs 31, 30) et enfin, un troisième moyen de focalisation 40 entre le miroir 30 et la première chambre 1.

En variante, on peut supprimer le troisième moyen de focalisation 40 en conservant les deux autres moyens de focalisation 40, 41. Dans ce cas, seul le faisceau laser 10 passant par la deuxième chambre 2 est focalisé.

Selon une autre variante, il est encore possible de conserver uniquement le troisième moyen de focalisation 40, sans mettre en oeuvre les deux autres 42, 43. Dans ce cas, seul le faisceau laser 10 passant par la première chambre 1 est focalisé.

Par ailleurs, on peut supprimer les moyens de focalisation et ne conserver que les miroirs plans.

Selon une autre variante, on remplace les miroirs plans 30, 31, 33 par des miroirs concaves remplissant également la fonction de focalisation du faisceau laser.

Par ailleurs, une lame séparatrice 50 peut être prévue entre la deuxième chambre 2 et la première chambre 1 en référence au sens de parcours du faisceau laser 10 et avantageusement entre les deux miroirs 30, 31. Cette lame est par exemple réalisée en ZnSe. On peut ainsi contrôler le rapport de la puissance du faisceau laser 10 traversant la première chambre 1 sur la puissance du faisceau laser traversant la deuxième chambre 2.

Bien entendu, on pourrait disposer le laser 8 en vis-à-vis de la deuxième chambre 2, ce qui permettrait de supprimer les miroirs 32, 33.

Si l'on souhaite s'affranchir d'un éventuel problème de puissance disponible du faisceau laser entre les deux chambres, il est encore envisageable de mettre en oeuvre un dispositif optique 202 comportant deux lasers 8, 80, chaque laser étant dédié à l'éclairement de l'une des deux chambres 1, 2 (faisceau laser 10 ou faisceau laser 110, respectivement).

Cette possibilité est représentée sur la figure 3(c).

Chaque laser 8, 80 est alors disposé sur le côté du réacteur 100, en vis-à-vis de l'une des deux chambres. Chaque faisceau laser 10, 110 traverse donc la chambre associée latéralement.

Avantageusement, à chaque laser 8, 80 est associé un moyen de focalisation 40, 42 servant à définir les zones d'interaction 5, 7 précitées. En variante, aucun moyen de focalisation n'est mis en oeuvre ou bien l'un seulement des deux lasers 8, 80 est associé à un tel moyen de focalisation.

Enfin, il est également envisageable de mettre en oeuvre un dispositif optique 203 capable d'éclairer les deux chambres 1, 2 en parallèle avec un seul laser 8. Le laser 8 peut alors être positionné, par rapport au réacteur 100, comme sur les figures 3(a) ou 3(b). A cet effet, une lame séparatrice 51 est nécessaire pour séparer le faisceau laser 10 issu du laser 8 en deux faisceaux 111, 112. Cette lame 51 peut être réalisée en ZnSe. Elle peut, en fonction des besoins, être définie pour transmettre plus de puissance à l'une des deux chambres 1, 2 ou transmettre une puissance égale à chaque chambre 1, 2. Au moins un miroir 33, de préférence plan, est dans ce cas nécessaire.

Cette dernière possibilité est représentée sur la figure 3(d).

Il convient de noter que cette dernière possibilité est particulièrement souple dans son utilisation. En effet, elle permet de contrôler la puissance d'éclairement injectée dans chaque chambre 1, 2 sans être contraint par un rapport de puissance entre les deux chambres comme pour les variantes des figures 3(a) et 3(b). Et elle évite l'emploi de deux lasers comme pour la variante représentée sur la figure 3(c).

Avantageusement, à chaque faisceau laser 111, 112 est associé un moyen de focalisation 40, 42 qui sert à définir les zones d'interaction 5, 7 précitées. Dans ce cas, le miroir 33 est un miroir plan.

En variante, l'un seulement des deux faisceaux lasers 111, 112 est associé à un tel moyen de focalisation. Dans le cas où seul le faisceau laser 112 passant par le miroir 33 est focalisé, le miroir 33 est plan.

Le miroir plan 33 et le moyen de focalisation 42 représentés sur la figure 3(d) peuvent être remplacés par un miroir concave remplissant également la fonction de focalisation remplie par le moyen de focalisation 42.

Selon une autre variante, aucun moyen de focalisation n'est prévu.

Quelle que soit la variante envisagée pour le dispositif optique, le laser 8, 80 peut être un laser de type CO₂ émettant à une longueur d'onde de 10,6 microns. D'autres types de lasers connus de l'homme du métier pour leur capacité à décomposer certains précurseurs peuvent être envisagés.

Chaque moyen de focalisation 40, 41, 42, 43 peut être formé par une lentille sphérique ou une ou deux lentille(s) cylindrique(s). Sur les figures 3(a) à 3(d), chaque moyen de focalisation 40, 41, 42, 43 est constitué de deux lentilles cylindriques.

Lorsqu'une lentille sphérique est employée, on peut faire varier le diamètre de la tâche focale définissant le coeur de la zone d'interaction en modifiant la distance entre la lentille et la zone d'interaction. Avec une lentille cylindrique, on peut faire varier la hauteur de la tâche focale en modifiant la distance entre la lentille et la zone d'interaction. Avec deux lentilles cylindriques, on peut faire varier à la fois la largeur et la hauteur de la tâche focale en modifiant d'une part, la distance entre les deux lentilles et d'autre part, la distance entre le couple de lentilles et la zone d'interaction.

Il convient de noter que modifier la distance entre le moyen de focalisation (40, 42 sur la figure 3(a) ; 42, 40 sur la figure 3(b) ; 40 et/ou 42 sur les figures 3(c) et 3(d)) du faisceau laser 10 et la zone d'interaction entre ce faisceau laser 10 et les précurseurs revient, en pratique, à modifier la distance entre ce moyen de focalisation et la chambre 1, 2 avoisinante (sur la figure 3(a) par exemple, le moyen de focalisation 40 est celui qui avoisine la première chambre 1 et le moyen de focalisation 42 celui qui avoisine la deuxième chambre 2), dans laquelle se trouve la zone d'interaction.

Ces différents moyens de focalisation permettent donc, en modifiant la position des lentilles, de définir, pour un laser donné, la puissance incidente par unité de surface (fluence) du faisceau laser et donc la température au sein de cette zone.

Cela confère au dispositif une grande adaptabilité, utile pour synthétiser différents types de nanoparticules de type coeur-coquille. Le choix s'effectue en fonction de la nature chimique des précurseurs destinés à former le coeur et la coquille des nanoparticules coeur-coquille.

On peut prendre l'exemple d'une lentille sphérique de focale F' = 750mm, dont la position est ajustable d'une distance comprise entre 750mm et 1060mm par rapport à la zone d'interaction entre le faisceau laser et les précurseurs.

Selon cet exemple, le diamètre de la tâche focale est alors ajustable, en fonction de la position de la lentille, entre une valeur minimum proche de 0,5mm et une valeur maximum de quelques millimètres. Le diamètre minimal de la tâche focale est obtenu lorsque la distance entre la lentille et la zone d'interaction entre le laser et les précurseurs est égale à la focale de la lentille. Au contraire, les dimensions maximales de la tâche focale sont obtenues lorsque la distance entre la lentille et le point d'interaction du laser et des précurseurs est la plus grande. De cette manière, il est possible de faire varier la fluence incidente du laser au point d'interaction en gardant une puissance laser incidente constante. La fluence incidente du laser au point d'interaction peut avoir une influence sur l'efficacité de décomposition des précurseurs.

En utilisant deux lentilles cylindriques à la place d'une lentille sphérique, et en croisant leurs plans de focalisation, on ajuste séparément, en jouant sur la distance de chaque lentille par rapport à la zone d'interaction, la hauteur et la largeur de la tache focale.

Si l'on souhaite réduire les dimensions minimum de cette tâche focale, il est envisageable de mettre en oeuvre un élargisseur de faisceau (non représenté) en sortie du laser 8, 80. Ainsi, avec un laser CO₂ fonctionnant à une longueur d'onde de 10,6 microns, un faisceau laser élargi à 45mm de diamètre et une lentille sphérique de focale de 150mm, on peut espérer atteindre une tâche focale de l'ordre de 170microns.

Les dimensions de la tâche focale peuvent également être adaptées, en particulier en modifiant la fluence du faisceau laser, avec des miroirs concaves. A cet effet, on règle alors la position du miroir concave par rapport à la chambre avoisinante du réacteur.

Le réacteur 100 du dispositif selon l'invention décrit à l'appui de la figure 2 peut être modifié.

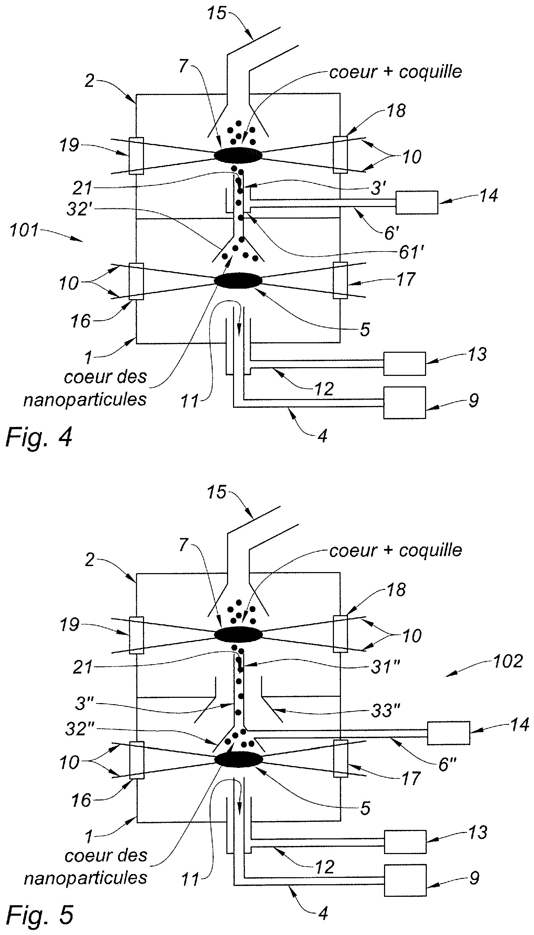

La figure 4 représente ainsi une variante de réalisation du réacteur. Elle se caractérise, pour l'essentiel, par une inversion de la disposition du canal d'amenée 6' des précurseurs de la coquille par rapport au canal de communication 3 ; le mélange entre les deux s'effectuant dans les deux cas dans la deuxième chambre 2.

Dans ce réacteur 101, le précurseur de la coquille est amené avec un canal d'amenée 6' dont l'extrémité entoure le canal de communication 3' entre les deux chambres 1, 2. Le mélange entre le précurseur de la coquille et le coeur des nanoparticules s'effectue donc dans la deuxième chambre 2 elle-même. Ce mélange doit s'effectuer avant la zone d'interaction 7 avec le faisceau laser 10.

La situation est donc assez proche de celle qui est rencontrée avec la variante de la figure 2 sur la question des conditions de débit.

Cependant, la largeur du canal de communication 3' entre les deux chambres étant plus faible que celle du canal de communication 3 (figure 2), le coeur des nanoparticules peut être confiné sur une faible étendue, ce qui est particulièrement bien adapté avec une focalisation du laser 8.

Avantageusement, le canal de communication 3' comprend une partie inférieure 32', logée dans la première chambre 1, qui se présente sous la forme d'un cône pour améliorer la récupération du coeur des nanoparticules. La figure 5 représente une autre variante de réalisation de ce réacteur. Dans cette variante, les précurseurs de la coquille sont mélangés aux particules de coeur avant l'arrivée dans la deuxième chambre 2.

Dans ce réacteur 102, le canal 6" d'amenée du précurseur de la coquille débouche dans le canal de communication 3" entre les deux chambres 1, 2. L'entrée 21 du précurseur de la coquille dans la deuxième chambre 2 se confond alors avec l'extrémité du canal de communication 3" qui débouche dans la deuxième chambre 2.

En comparaison aux réalisations des figures 2 et 4, cette disposition permet d'assurer un mélange encore plus homogène du précurseur de la coquille avec le coeur des nanoparticules formées dans la première chambre 1. Ceci est lié au fait que le canal de communication 3" présente une colonne 31" suffisamment longue pour favoriser l'homogénéité de ce mélange.

Avantageusement, l'extrémité inférieure du canal de communication 3", logée dans la première chambre 1, présente une forme de cône 32" favorisant la récupération du coeur des nanoparticules.

Il convient par ailleurs de noter qu'un mélange homogène peut être obtenu pour de larges variations des conditions de débit pour le précurseur du coeur ou le précurseur de la coquille. En particulier, pour des débits élevés, il est avantageusement prévu un canal de communication complémentaire 33" entre les deux chambres 1, 2, dont les parois définissent par exemple une forme de cône, entourant le canal de communication 3" afin que le gaz neutre qui ne peut pas passer par le canal de communication 3" passe autour. Ceci permet d'améliorer l'homogénéité du mélange entre le coeur des nanoparticules, ce gaz neutre et le précurseur du coeur au sein de la deuxième chambre 2. Par suite, les nanoparticules formées présentent une excellente homogénéité de la répartition de la coquille autour du coeur.

Dans des conditions de débit plus faibles, le canal de communication complémentaire 33" peut être supprimé.

### Exemple de réalisation : Synthèse de nanoparticules dont le coeur est en silicium et la coquille en carbone.

Le dispositif optique 200 employé est celui de la figure 3(a), sans lame séparatrice. Des moyens de focalisation 40, 41 ont été utilisés entre le laser 8 et la première chambre 1 et en sortie de la première chambre 1. Plus précisément, une lentille cylindrique 40 de focale 500mm a été placée entre le laser 8 et la première chambre 1 et une lentille similaire 41 a été placée en sortie de la première chambre 1, à 1000mm de la lentille 41. La lentille 41 sert à collimater à nouveau le faisceau laser 10 avant le passage par les miroirs 30, 31. Aucune focalisation n'a été effectuée pour le faisceau laser entrant dans la deuxième chambre 2.

Le réacteur 100 est celui qui est représenté sur la figure 2. Le silane est utilisé comme précurseur du coeur (silicium). De l'éthylène est utilisé comme précurseur de la coquille (carbone).

Les paramètres suivants sont utilisés :
- débit silane (chambre 1) = 46sccm ;
- débit éthylène (chambre 2) = 406sccm :
- puissance du laser = 560W
- pression dans le réacteur = atmosphérique ;
- diamètre entrée 11 = 2mm ;
- diamètre entrée 21 = 10mm ;
- diamètre (d₁) canal de communication 3 du côté de la deuxième chambre = 24mm
- diamètre (d₂) de la cheminée entourant le canal 4 = 20mm.

Des particules de silicium de 100nm environ enrobées par une coquille en carbone d'environ 5nm à 10nm d'épaisseur ont ainsi pu être obtenues.

Ces nanoparticules peuvent notamment être utilisées pour former des matériaux d'anode dans les batteries lithium-ion.

Par ailleurs, pour donner d'autres exemples, il est possible de synthétiser des nanoparticules présentant à la fois des propriétés de luminescence et des propriétés magnétiques. Ainsi, on peut synthétiser des nanoparticules dont le coeur est réalisé en silicium (pour la luminescence) et la coquille dans un matériau tel que le Fer ou un oxyde de fer (pour les propriétés magnétiques). Au contraire, il est possible de réaliser des nanoparticules dont le coeur est réalisé en un matériau présentant des propriétés magnétiques (Fer, oxyde de Fer,...) avec une coquille en silicium.

L'invention concerne également un procédé de synthèse de nanoparticules de type coeur-coquille par pyrolyse laser, caractérisé en ce qu'il comprend les étapes suivantes :
(a) injecter un précurseur du coeur dans une première chambre d'un réacteur;
(b) éclairer le précurseur du coeur par un faisceau laser afin de former par pyrolyse le coeur des nanoparticules ;
(c) transporter le coeur des nanoparticules ainsi formé à l'étape (b) dans une deuxième chambre du réacteur communiquant avec la première chambre ;
(d) injecter un précurseur de la coquille dans la deuxième chambre du réacteur;
(e) éclairer le précurseur de la coquille avec un faisceau laser afin de former par pyrolyse la coquille des nanoparticules et d'assurer le dépôt de cette coquille autour du coeur.

Du point de vue d'une nanoparticule, on crée ainsi son coeur dans la première chambre puis sa coquille dans la deuxième chambre. Toutefois, ce procédé s'effectue bien en continu dans la mesure où les étapes d'injection s'effectuent en continu. En injectant les précurseurs, on obtient donc grâce à la pyrolyse laser un flux continu de nanoparticules de type coeur-coquille en sortie du réacteur.

L'étape (a) et/ou l'étape (d) s'effectue(nt) à l'aide d'un gaz neutre tel que l'argon.

Par ailleurs, le procédé peut comprendre une étape consistant à modifier la distance entre un moyen de focalisation du faisceau laser et la chambre du réacteur avoisinante. Ce réglage permet, pour un laser de puissance donnée, de modifier la fluence du faisceau laser dans la zone d'interaction 5, 7.

Enfin, une étape (f) consistant à collecter les nanoparticules ainsi formées à l'issue de l'étape (e) pour obtenir un matériau nanocomposite peut être réalisée.

La pression dans le réacteur 100 peut être la même dans les deux chambres 1, 2. Toutefois, et comme précisé précédemment, on peut prévoir de maintenir une pression plus élevée dans la première chambre 1 que dans la deuxième chambre 2, afin de favoriser, selon le cas, une réaction homogène (formation d'un coeur en silicium, par exemple) ou une réaction hétérogène (dépôt de la coquille en carbone autour d'un coeur en silicium, par exemple).

Les différentes variantes du dispositif selon l'invention décrites précédemment peuvent être utilisées pour d'autres applications que la synthèse en continu de nanoparticules de type coeur-coquille.

En effet, il est possible d'utiliser le réacteur 100, 101, 102 pour effectuer un recuit de nanoparticules.

A cet effet, on forme des nanoparticules en injectant un précurseur par l'entrée 11 de la première chambre 1, mais aucun précurseur n'est introduit par l'entrée 21 de la deuxième chambre 2. Les nanoparticules sont ainsi formées dans la première chambre 1 par pyrolyse laser, puis transmises dans la deuxième chambre 2 où le faisceau laser chauffe à nouveau ces nanoparticules, de manière contrôlée. Ce contrôle s'effectue notamment en choisissant la puissance du laser, la lame séparatrice ou en réglant focalisation du faisceau laser.

Ce recuit peut servir à modifier le volume des nanoparticules sans coalescence avec d'autres nanoparticules ou, au contraire, à favoriser la coalescence de nanoparticules entre elles (avec apport de matière, c'est-à-dire avec apport d'un précurseur via l'entrée 21 de la deuxième chambre de nature identique au précurseur introduit dans la première chambre par l'entrée 11, ou non).

Ce recuit peut également être un recuit de surface, par exemple pour corriger des défauts de surface (passivation). Au contraire, ce recuit de surface peut servir à activer des sites réactionnels à la surface des nanoparticules, en fonction de l'atmosphère de traitement laquelle est déterminée par la nature du gaz porteur du précurseur.

Ce recuit peut également servir à compléter la décomposition du précurseur injecté dans la première chambre, si la pyrolyse dans la première chambre s'avérait ne pas être complète.

L'utilisation du dispositif selon l'invention dans ce but évite donc d'effectuer un recuit avec un dispositif externe.

Comme on peut le noter, il n'est pas nécessaire, pour cette application de recuit, de prévoir, au sein du dispositif, des moyens (6, 21, 14 sur la figure 2 ; 6', 14 sur la figure 4 ; 6", 14 sur la figure 5) pour injecter un précurseur de coquille.

En d'autres termes, pour cette application de recuit de nanoparticules, le dispositif peut alors comprendre :
- un réacteur 100, 101, 102 comportant :
   - une première chambre 1 pour la synthèse des nanoparticules, laquelle est munie d'une entrée 11 pour un précurseur de ces nanoparticules ;
   - une deuxième chambre 2 pour le recuit des nanoparticules ;
   - au moins un canal de communication 3, 3', 3" entre les deux chambres 1, 2 pour les nanoparticules destinées à être formées dans la première chambre 1 en direction de la deuxième chambre 2 ;
- un dispositif optique 200, 201, 202, 203 pour éclairer chacune des deux chambres 1, 2, ce dispositif comportant au moins un laser 8, 80 apte à émettre un faisceau laser 10, 101 destiné à interagir avec lesdits précurseurs afin de former le coeur et la coquille.

Les différentes variantes du dispositif de synthèse de nanoparticules de type coeur-coquille décrites à l'appui des figures annexées son transposables au dispositif qui peut être modifié pour servir au recuit de nanoparticules, ces variantes ne comportant alors pas l'ensemble des moyens nécessaires pour injecter un précurseur de coquille dans la deuxième chambre.

## Revendications

1. Dispositif de synthèse de nanoparticules de type coeur-coquille par pyrolyse laser, **caractérisé en ce qu'**il comprend :
- un réacteur (100, 101, 102) comportant :
• une première chambre (1) pour la synthèse du coeur, laquelle est munie d'une entrée (11) pour un précurseur du coeur ;
• une deuxième chambre (2) pour la synthèse de la coquille, laquelle est munie d'une entrée (21) pour un précurseur de la coquille ; et
• au moins un canal de communication (3, 3', 3") entre les deux chambres (1, 2) pour transmettre le coeur des nanoparticules destinées à être formées dans la première chambre (1) en direction de la deuxième chambre (2) ;
- un dispositif optique (200, 201, 202, 203) pour éclairer chacune des deux chambres (1, 2), ce dispositif comportant au moins un laser (8, 80) apte à émettre un faisceau laser (10, 101) destiné à interagir avec lesdits précurseurs afin de former le coeur et la coquille.

2. Dispositif selon la revendication 1, **caractérisé en ce que** le dispositif optique (200, 201, 202, 203) comprend une pluralité de miroirs (30, 31, 32, 33) agencés de sorte que le faisceau laser émis par le laser (8) soit apte à éclairer successivement les deux chambres.

3. Dispositif selon la revendication précédente, **caractérisé en ce que** le dispositif optique (200, 201, 202, 203) comprend au moins une lame séparatrice (50) pour régler la puissance du faisceau laser dans chacune des deux chambres, cette lame séparatrice étant par exemple située entre deux miroirs (30, 31).

4. Dispositif selon la revendication 1, **caractérisé en ce que** le dispositif optique (200, 201, 202, 203) comprend une lame séparatrice (51) et au moins un miroir (33) agencés de sorte que le faisceau laser (10) émis par le laser soit divisé en deux faisceaux (111, 112) chacun apte à éclairer l'une des deux chambres.

5. Dispositif selon la revendication 1, **caractérisé en ce que** le dispositif optique (200, 201, 202, 203) comprend un premier laser (8) pour éclairer la première chambre (1) et un deuxième laser (80) pour éclairer la deuxième chambre (2).

6. Dispositif selon l'une des revendications précédentes, **caractérisé en ce que** le dispositif optique (200, 201, 202, 203) comprend au moins un moyen de focalisation (40, 41, 42, 43) disposé entre le ou chaque laser (8, 80) et au moins l'une des deux chambres, la distance entre ledit au moins un moyen de focalisation (40, 41, 42, 43) et la chambre (1, 2) avoisinante étant avantageusement réglable.

7. Dispositif selon la revendication 6, **caractérisé en ce que** le moyen de focalisation (40, 41, 42, 43) comportant deux lentilles cylindriques, la distance entre les deux lentilles cylindriques est réglable.

8. Dispositif selon l'une des revendications précédentes, **caractérisé en ce que** l'entrée (21) du précurseur de la coquille dans la deuxième chambre (2) forme une extrémité d'un canal d'amenée (6) de ce précurseur dont une partie (61) est logée à l'intérieur du canal de communication (3) entre les deux chambres (1, 2).

9. Dispositif selon l'une des revendications 1 à 7, **caractérisé en ce que** l'entrée (21) du précurseur de la coquille dans la deuxième chambre (2) forme une extrémité d'un canal d'amenée (6') de ce précurseur dont une partie (61') entoure le canal de communication (3') entre les deux chambres (1, 2).

10. Dispositif selon l'une des revendications 8 ou 9, **caractérisé en ce que** la partie (61, 61') du canal d'amenée (6, 6') du précurseur de la coquille qui est, selon le cas, logée à l'intérieur du canal de communication (3) ou qui entoure ce canal de communication (3') s'étend colinéairement avec le canal de communication (3, 3').

11. Dispositif selon l'une des revendications 1 à 7, **caractérisé en ce que** le réacteur (102) comprend un canal d'amenée (6") du précurseur de la coquille débouchant dans le canal de communication (3") entre les deux chambres (1, 2), l'entrée (21) du précurseur de la coquille se confondant alors avec l'extrémité du canal de communication (3") entre les deux chambres qui débouche dans la deuxième chambre.

12. Dispositif selon la revendication précédente, **caractérisé en ce que** le réacteur (102) comprend un canal (33") complémentaire de communication entre les deux chambres (1, 2), entourant le canal de communication (3") entre ces deux chambres.

13. Dispositif selon l'une des revendications précédentes, **caractérisé en ce que** l'entrée (11) du précurseur du coeur dans la première chambre (1) forme une extrémité d'un canal d'amenée (4) de ce précurseur dont une partie est entourée par une partie d'un canal (12) relié à une source (13) de gaz neutre.

14. Dispositif selon la revendication précédente, **caractérisé en ce que** la partie du canal d'amenée (4) du précurseur du coeur qui est entourée par une partie du canal (12) relié à la source (13) de gaz neutre s'étend colinéairement avec cette partie dudit canal (12).

15. Procédé de synthèse de nanoparticules de type coeur-coquille par pyrolyse laser, **caractérisé en ce qu'**il comprend les étapes suivantes :
(a) injecter un précurseur du coeur dans une première chambre d'un réacteur;
(b) éclairer le précurseur du coeur par un faisceau laser afin de former par pyrolyse le coeur des nanoparticules ;
(c) transporter le coeur des nanoparticules ainsi formé à l'étape (b) dans une deuxième chambre du réacteur communiquant avec la première chambre ;
(d) injecter un précurseur de la coquille dans la deuxième chambre du réacteur ;
(e) éclairer le précurseur de la coquille avec un faisceau laser afin de former par pyrolyse la coquille des nanoparticules et d'assurer le dépôt de cette coquille autour du coeur.

16. Procédé selon la revendication 15, **caractérisé en ce que** la pression régnant dans la première chambre (1) est plus élevée que la pression régnant dans la deuxième chambre (2).

## Patentansprüche

1. Vorrichtung zur Synthese von Nanopartikeln vom Typ Kern/Hülle durch Laserpyrolyse, **dadurch gekennzeichnet, dass** sie umfasst:
- einen Reaktor (100, 101, 102), aufweisend:
• eine erste Kammer (1) für die Synthese des Kerns, die mit einem Einlass (11) für einen Vorläufer des Kerns ausgestattet ist;
• eine zweite Kammer (2) für die Synthese der Hülle, die mit einem Einlass (21) für einen Vorläufer der Hülle ausgestattet ist; und
• mindestens einen Kommunikationskanal (3, 3', 3") zwischen den zwei Kammern (1, 2), um den Kern der Nanopartikel, die dazu bestimmt sind, in der ersten Kammer (1) gebildet zu werden, in Richtung der zweiten Kammer (2) zu übertragen;
- eine optische Vorrichtung (200, 201, 202, 203), um jede der zwei Kammern (1, 2) zu beleuchten, wobei diese Vorrichtung mindestens einen Laser (8, 80) aufweist, der einen Laserstrahl (10, 101) emittieren kann, welcher imstande ist, mit den Vorläufern zu interagieren, um den Kern und die Hülle zu bilden.

2. Vorrichtung nach Anspruch 1, **dadurch gekennzeichnet, dass** die optische Vorrichtung (200, 201, 202, 203) eine Vielzahl von Spiegeln (30, 31, 32, 33) umfasst, die so eingerichtet sind, dass der vom Laser (8) emittierte Laserstrahl die zwei Kammern nacheinander beleuchten kann.

3. Vorrichtung nach dem vorstehenden Anspruch, **dadurch gekennzeichnet, dass** die optische Vorrichtung (200, 201, 202, 203) mindestens einen Strahlteiler (50) umfasst, um die Leistung des Laserstrahls in jeder der zwei Kammern einzustellen, wobei dieser Strahlteiler zum Beispiel zwischen zwei Spiegeln (30, 31) liegt.

4. Vorrichtung nach Anspruch 1, **dadurch gekennzeichnet, dass** die optische Vorrichtung (200, 201, 202, 203) einen Strahlteiler (51) und mindestens einen Spiegel (33) umfasst, die so eingerichtet sind, dass der vom Laser emittierte Laserstrahl (10) in zwei Strahlen (111, 112) geteilt wird, die jeder eine der zwei Kammern beleuchten können.

5. Vorrichtung nach Anspruch 1, **dadurch gekennzeichnet, dass** die optische Vorrichtung (200, 201, 202, 203) einen ersten Laser (8) umfasst, um die erste Kammer (1) zu beleuchten, und einen zweiten Laser (80), um die zweite Kammer (2) zu beleuchten.

6. Vorrichtung nach einem der vorstehenden Ansprüche, **dadurch gekennzeichnet, dass** die optische Vorrichtung (200, 201, 202, 203) mindestens ein Fokussiermittel (40, 41, 42, 43) umfasst, das zwischen dem oder jedem Laser (8, 80) und mindestens einer der zwei Kammern angeordnet ist, wobei der Abstand zwischen dem mindestens einen Fokussiermittel (40, 41, 42, 43) und der benachbarten Kammer (1, 2) vorteilhafterweise einstellbar ist.

7. Vorrichtung nach Anspruch 6, **dadurch gekennzeichnet, dass** wenn das Fokussiermittel (40, 41, 42, 43) zwei Zylinderlinsen aufweisen, der Abstand zwischen den zwei Zylinderlinsen einstellbar ist.

8. Vorrichtung nach einem der vorstehenden Ansprüche, **dadurch gekennzeichnet, dass** der Einlass (21) des Vorläufers der Hülle in der zweiten Kammer (2) ein Ende eines Zuführkanals (6) dieses Vorläufers bildet, von dem ein Teil (61) im Inneren des Kommunikationskanals (3) zwischen den zwei Kammern (1, 2) untergebracht ist.

9. Vorrichtung nach einem der Ansprüche 1 bis 7, **dadurch gekennzeichnet, dass** der Einlass (21) des Vorläufers der Hülle in der zweiten Kammer (2) ein Ende eines Zuführkanals (6') dieses Vorläufers bildet, von dem ein Teil (61') den Kommunikationskanal (3') zwischen den zwei Kammern (1, 2) umgibt.

10. Vorrichtung nach einem der Ansprüche 8 oder 9, **dadurch gekennzeichnet, dass** der Teil (61, 61') des Zuführkanals (6, 6') des Vorläufers der Hülle, der je nach Fall im Inneren des Kommunikationskanals (3) untergebracht ist oder der diesen Kommunikationskanal (3') umgibt, sich kollinear mit dem Kommunikationskanal (3, 3') erstreckt.

11. Vorrichtung nach einem der Ansprüche 1 bis 7, **dadurch gekennzeichnet, dass** der Reaktor (102) einen Zuführkanal (6") des Vorläufers der Hülle umfasst, der in den Kommunikationskanal (3") zwischen den zwei Kammern (1, 2) mündet, wobei der Einlass (21) des Vorläufers der Hülle dann mit dem Ende des Kommunikationskanals (3") zwischen den zwei Kammern, das in die zweite Kammer mündet, verschmilzt.

12. Vorrichtung nach dem vorstehenden Anspruch, **dadurch gekennzeichnet, dass** der Reaktor (102) einen zusätzlichen Kommunikationskanal (33") zwischen den zwei Kammern (1, 2) umfasst, der den Kommunikationskanal (3") zwischen diesen zwei Kammern umgibt.

13. Vorrichtung nach einem der vorstehenden Ansprüche, **dadurch gekennzeichnet, dass** der Einlass (11) des Vorläufers des Kerns in der ersten Kammer (1) ein Ende eines Zuführkanals (4) dieses Vorläufers bildet, von dem ein Teil von einem Teil eines Kanals (12) umgeben ist, der mit einer Neutralgasquelle (13) verbunden ist.

14. Vorrichtung nach dem vorstehenden Anspruch, **dadurch gekennzeichnet, dass** der Teil des Zuführkanals (4) des Vorläufers des Kerns, der von einem Teil des mit der Neutralgasquelle (13) verbundenen Kanals (12) umgeben ist, sich kollinear mit diesem Teil des Kanals (12) erstreckt.

15. Verfahren zur Synthese von Nanopartikeln vom Typ Kern/Hülle durch Laserpyrolyse, **dadurch gekennzeichnet, dass** es die folgenden Schritte umfasst:
(a) Einspritzen eines Vorläufers des Kerns in eine erste Kammer eines Reaktors;
(b) Beleuchten des Vorläufers des Kerns mit einem Laserstrahl, um durch Pyrolyse den Kern der Nanopartikel zu bilden;
(c) Transportieren des so im Schritt (b) gebildeten Kerns der Nanopartikel in eine zweite Kammer des Reaktors, die mit der ersten Kammer kommuniziert;
(d) Einspritzen eines Vorläufers der Hülle in die zweite Kammer des Reaktors;
(e) Beleuchten des Vorläufers der Hülle mit einem Laserstrahl, um durch Pyrolyse die Hülle der Nanopartikel zu bilden und um die Abscheidung dieser Hülle um den Kern herum sicherzustellen.

16. Verfahren nach Anspruch 15, **dadurch gekennzeichnet, dass** der Druck, der in der ersten Kammer (1) herrscht, höher ist als der Druck, der in der zweiten Kammer (2) herrscht.

## Claims

1. Device for synthesising core-shell nanoparticles by laser pyrolysis, **characterised in that** it comprises:
- a reactor (100, 101, 102) comprising:
• a first chamber (1) for the synthesis of the core, which is equipped with an inlet (11) for a core precursor;
• a second chamber (2) for the synthesis of the shell, which is equipped with an inlet (21) for a shell precursor; and
• at least one communication channel (3, 3', 3") between the two chambers (1, 2) for transmitting the nanoparticle cores to be formed in the first chamber (1) in the direction of the second chamber (2);
- an optical device (200, 201, 202, 203) for illuminating each of the two chambers (1, 2), said device comprising at least one laser (8, 80) capable of emitting a laser beam (10, 101) intended to interact with said precursors in order to form the core and the shell.

2. Device according to claim 1, **characterised in that** the optical device (200, 201, 202, 203) comprises a plurality of mirrors (30, 31, 32, 33) arranged such that the laser beam emitted by the laser (8) is able to illuminate the two chambers in succession.

3. Device according to the preceding claim, **characterised in that** the optical device (200, 201, 202, 203) comprises at least one beam splitter (50) for adjusting the power of the laser beam in each of the two chambers, this beam splitter, for example, being located between two mirrors (30, 31).

4. Device according to claim 1, **characterised in that** the optical device (200, 201, 202, 203) comprises a beam splitter (51) and at least one mirror (33) arranged such that the laser beam (10) emitted by the laser is divided into two beams (111, 112) each able to illuminate one of the two chambers.

5. Device according to claim 1, **characterised in that** the optical device (200, 201, 202, 203) comprises a first laser (8) for illuminating the first chamber (1) and a second laser (80) for illuminating the second chamber (2).

6. Device according to one of the preceding claims, **characterised in that** the optical device (200, 201, 202, 203) comprises at least one focusing means (40, 41, 42, 43) placed between the or each laser (8, 80) and at least one of the two chambers, wherein the distance between said at least one focusing means (40, 41, 42, 43) and the neighbouring chamber (1, 2) being advantageously adjustable.

7. Device according to claim 6, **characterised in that** the focusing means (40, 41, 42, 43) comprises two cylindrical lenses, where the distance between the two cylindrical lenses is adjustable.

8. Device according to one of the preceding claims, **characterised in that** the inlet (21) of the shell precursor into the second chamber (2) forms an end of a feed channel (6) of this precursor, one portion (61) of which is housed inside the communication channel (3) between two chambers (1, 2).

9. Device according to one of claims 1 to 7, **characterised in that** the inlet (21) of the shell precursor into the second chamber (2) forms an end of a feed channel (6') of this precursor, one portion (61') of which surrounds the communication channel (3') between the two chambers (1, 2).

10. Device according to one of claims 8 or 9, **characterised in that** the portion (61, 61') of the feed channel (6, 6') of the shell precursor, which depending on the case, is housed inside the communication channel (3) or which surrounds this communication channel (3') extends colinearly with the communication channel (3, 3').

11. Device according to one of claims 1 to 7, **characterised in that** the reactor (102) comprises a feed channel (6") of the shell precursor, opening into the communication channel (3") between the two chambers (1, 2), the inlet (21) of the shell precursor thus combining with the end of the communication channel (3") between the two chambers which opens into the second chamber.

12. Device according to the preceding claim, **characterised in that** the reactor (102) comprises a complementary communication channel (33") between the two chambers (1, 2), surrounding the communication channel (3") between these two chambers.

13. Device according to one of the preceding claims, **characterised in that** the inlet (11) of the core precursor into the first chamber (1) forms an end of a feed channel (4) of this precursor, one portion of which is surrounded by a portion of the channel (12) connected to a neutral gas source (13).

14. Device according to the preceding claim, **characterised in that** the portion of the feed channel (4) of the core precursor which is surrounded by a portion of the channel (12) connected to the neutral gas source (13), extends colinearly with this portion of said channel (12).

15. Method for synthesising core-shell nanoparticles by laser pyrolysis, **characterised in that** it comprises the following steps:
(a) injecting a core precursor into a first chamber of a reactor;
(b) illuminating the core precursor with a laser beam in order to form, by pyrolysis, nanoparticle cores;
(c) transporting the nanoparticle cores thus formed in step (b) into a second chamber of the reactor communicating with the first chamber;
(d) injecting a shell precursor into the second chamber of the reactor;
(e) illuminating the shell precursor with a laser beam in order to form, by pyrolysis, the shell of the nanoparticles and to ensure this shell is deposited around the core.

16. Method according to claim 15, **characterised in that** the pressure in the first chamber (1) is higher than the pressure in the second chamber (2).
